# EUROPÄISCHE PATENTSCHRIFT

(11) **EP 3 636 048 B1**
(45) Veröffentlichungstag und Bekanntmachung des Hinweises auf die Patenterteilung: **31.07.2024**
(21) Anmeldenummer: 18730650.1
(22) Anmeldetag: 23.05.2018
(51) Int. Cl.: H05H 1/24, G01N 27/62, H01J 37/32, H01J 49/10

(54) **VERFAHREN ZUR IONISIERUNG VON GASFÖRMIGEN PROBEN MITTELS DIELEKTRISCH BEHINDERTER ENTLADUNG UND ZUR NACHFOLGENDEN ANALYSE DER ERZEUGTEN PROBENIONEN IN EINEM ANALYSEGERÄT**
METHOD FOR IONIZING GASEOUS SAMPLES BY MEANS OF A DIELECTRIC BARRIER DISCHARGE AND FOR SUBSEQUENTLY ANALYZING THE PRODUCED SAMPLE IONS IN AN ANALYSIS APPLIANCE
PROCÉDÉ D'IONISATION D'ÉCHANTILLONS GAZEUX PAR DÉCHARGE À BARRIÈRE DIÉLECTRIQUE, ET D'ANALYSE ULTÉRIEURE DES IONS ÉCHANTILLONS PRODUITS DANS UN APPAREIL D'ANALYSE

(30) Priorität: 09.06.2017 DE 102017112726
(43) Veröffentlichungstag der Anmeldung: 15.04.2020
(73) Patentinhaber: Leibniz - Institut für Analytische Wissenschaften - ISAS - e.V., 44139 Dortmund (DE)
(72) Erfinder: FRANZKE, Joachim, 44229 Dortmund (DE); KLUTE, Felix, David, 44892 Bochum (DE); BRANDT, Sebastian, 59755 Arnsberg (DE); VAUTZ, Wolfgang, 59425 Unna (DE)
(74) Vertreter: Meinke, Jochen
(86) Internationale Anmeldenummer: PCT/EP2018/063480
(87) Internationale Veröffentlichungsnummer: WO 2018/224307

(56) Entgegenhaltungen:
- EP-A1- 2 530 702
- WO-A1-2006/001455
- MICHELS ET AL: "Spectroscopic characterization of a microplasma used as ionization source for ion mobility spectrometry", SPECTROCHIMICA ACTA. PART B: ATOMIC SPECTROSCOPY, NEW YORK, NY, US, US, vol. 62, no. 11, 1 November 2007 (2007-11-01), pages 1208 - 1215, XP022357209, ISSN: 0584-8547, DOI: 10.1016/J.SAB.2007.08.004

## Beschreibung

Die Erfindung betrifft ein Verfahren zur Ionisierung von gasförmigen Proben mittels dielektrisch behinderter Entladung und zur nachfolgenden Analyse der erzeugten Probenionen in einem Analysegerät, insbesondere einem Massenspektrometer oder einem Ionenbeweglichkeitsspektrometer, wobei die Probenionen durch ein Plasma erzeugt werden, welches durch eine dielektrisch behinderte Entladung hervorgerufen wird, wobei die dielektrisch behinderte Entladung dadurch erzeugt wird, dass ein Plasmagas in ein hinteres Ende einer Kapillare aus einem dielektrischen Material in die Kapillare eingeleitet wird, wobei innerhalb der Kapillare eine drahtförmige Elektrode angeordnet ist, die hochspannungsseitig an eine Wechselspannungsquelle angeschlossen wird, wobei die gasförmige Probe dem Austrittsbereich der Kapillare zugeführt wird.

Aus DE 10 2006 050 136 A1 der Anmelderin ist ein Verfahren zur Ionisierung von gasförmigen Proben bekannt, wobei die Probenionen nach der Ionisierung in einem Analysegerät, nämlich einem Ionenbeweglichkeitsspektrometer oder ein Massenspektrometer, analysiert werden. Dabei wird ein Edelgas als Plasmagas durch eine Kapillare aus einem dielektrischen Material, z.B. Glas geführt, wobei angrenzend an den Austrittsbereich der Kapillare außenseitig an der Kapillare in einem Abstand von ca. 1 cm voneinander zwei Ringelektroden angeordnet sind. Durch das Anlegen einer Wechselhochspannung wird ein Plasma zwischen den Elektroden und ein Plasma am Austritt der Kapillare erzeugt. Zur Ionisierung einer gasförmigen Probe wird die gasförmige Probe von außen in den Austrittsbereich der Kapillare, d.h. in das Plasma am Austritt geführt und dort ionisiert, die gasförmige Probe selbst tritt nicht in die Kapillare ein. Die so erzeugten Probenionen gelangen anschließend in ein Ionenbeweglichkeitsspektrometer oder in ein Massenspektrometer und werden dort analysiert. Diese Art der Ionisierung, bei der beide Elektroden durch die Kapillare dielektrisch vom Plasmagas getrennt sind, wird auch als voll dielektrisch behindert bezeichnet.

Neben dieser voll dielektrisch behinderten Entladung ist auch eine halb dielektrisch behinderte Entladung bekannt, bei welcher nur eine Elektrode, nämlich diejenige, die hochspannungsseitig an die Hochspannungsquelle angeschlossen ist, an der Außenseite der Kapillare und dadurch dielektrisch vom Plasmagas getrennt angeordnet ist, während die zweite drahtförmige Elektrode innerhalb der Kapillare angeordnet und mit der Masse der Hochspannungsquelle verbunden ist, um zu vermeiden, dass von dieser Elektrode elektrische Durchschläge zum Einlass des Massenspektrometers auftreten können.

Bei beiden vorgenannten Konfigurationen ist die hochspannungsseitig mit der Hochspannungsquelle verbundene Elektrode an der Außenseite der Kapillare im Bereich des Austrittsendes angeordnet und damit in unmittelbarer Nachbarschaft zum Einlass des Massenspektrometers oder der Ionisationskammer des Ionenbeweglichkeitsspektrometers. Dies kann zu Kurzschlüssen und insbesondere bei der Ionenbeweglichkeitsspektrometrie zu Störungen des internen elektrischen Feldes führen. Außerdem ist es erforderlich, dass die an der Außenseite der Kapillare in der Regel ringförmig anliegende Elektrode gut isoliert ist, um Gefährdungen auszuschließen.

Aus EP 2 530 702 A1 ist ein Verfahren mit den Merkmalen des Oberbegriffs des Patentanspruchs 1 bekannt. Dabei wird eine starre Kapillare aus einem dielektrischen Material verwendet, welche an ihrer Außenseite im Austrittsbereich eine ringförmige zweite Elektrode aufweist, die an die Masse einer Hochspannungsquelle angeschlossen ist. Eine drahtförmige erste Elektrode ist hochspannungsseitig an die Hochspannungsquelle angeschlossen und ist durch ein hinteres Ende der Kapillare, in welches ein Plasmagas eingeleitet wird, in die Kapillare eingesetzt und erstreckt sich bis nah an den Austrittsbereich bis in den Bereich der zweiten Elektrode. Aufgrund dieser Gestaltung kann es ebenfalls zu Beeinflussungen des Analysegerätes kommen. Aus WO 2006/001455 A1 ist ein Plasmagenerator mit einer flexiblen Kapillare bekannt.

Aufgabe der Erfindung ist es deshalb, eine Beeinflussung des Analysegerätes durch die Wechselspannungsquelle für die Plasmaerzeugung zu vermeiden.

Diese Aufgabe wird bei einem Verfahren der eingangs bezeichneten Art erfindungsgemäß dadurch gelöst, dass eine flexible, biegbare Kapillare verwendet und die drahtförmige Elektrode nur in das hintere Ende der Kapillare eingesetzt wird, wobei keine an die Masse der Hochspannungsquelle angeschlossene Elektrode verwendet wird.

Im Unterschied zum Stand der Technik wird somit die innerhalb der Kapillare befindliche drahtförmige Elektrode hochspannungsseitig an die Hochspannungsquelle angeschlossen, wobei die Elektrode kürzer als die Kapillare ist, aber je nach Anwendungsfall grundsätzlich mit variabler Länge innerhalb der Kapillare angeordnet sein kann. An der Außenseite der Kapillare ist dann keine hochspannungsseitig an die Spannungsquelle angeschlossene Elektrode vorhanden, so dass es nicht zu Beeinflussungen des Analysegerätes kommen kann. Außerdem ist der Aufbau der Kapillare dadurch wesentlich einfacher, der elektrische Anschluss der Elektrode befindet sich entfernt vom Austritt der Kapillare am anderen Ende derselben, eine elektrische Isolierung zur Abschirmung gegenüber dem Analysegerät im Bereich des Austritts der Kapillare ist entbehrlich. Überraschend hat sich herausgestellt, dass mit einer derart gestalteten, halb dielektrisch behinderten Entladung eine wesentlich bessere Ionisierung des Probengases möglich ist. Für verwertbare Analyseergebnisse reicht ein Probengasstrom von etwa 10 bis 50 ml pro Minute gegenüber einem Probengasstrom von etwa 200 bis 300 ml pro Minute bei herkömmlichen Verfahren aus.

Dabei ist erfindungsgemäß vorgesehen, dass auf eine zweite, an die Masse der Hochspannungsquelle angeschlossene Elektrode verzichtet wird. Die Masse wir dann sozusagen von der Umgebung, z.B. dem Gehäuse des Analysegerätes gebildet, ein solcher Aufbau wirkt dann wie ein Kondensator. Durch die Verwendung einer flexiblen, biegbaren Kapillare hat sich überraschend herausgestellt, dass es möglich ist, ein Plasma zu erzeugen, das vom Ende der Elektrode bis zum Austritt der Kapillare reicht und zwar sowohl geradlinig als auch bogenförmig. Die Ausdehnung des Plasmas lässt sich durch die geometrischen Abmessungen des Elektrodendrahtes und der Kapillare und der Länge der Elektrode innerhalb der Kapillare beeinflussen.

In bevorzugter Ausgestaltung ist vorgesehen, dass als Plasmagas Helium, Argon, Wasserstoff, Stickstoff oder Luft verwendet wird. Es hat sich überraschender Weise herausgestellt, dass anders als bei herkömmlichen Verfahren nicht nur die vorgenannten Edelgase, sondern auch Wasserstoff, Stickstoff oder sogar Luft als Plasmagas geeignet sind.

Bevorzugt ist vorgesehen, dass als Wechselspannung eine Rechteckspannung verwendet wird.

Dabei beträgt die Frequenz der Rechteckspannung vorteilhaft 5 bis 60 kHz und es wird eine Rechteckspannung im Bereich von 1 bis 4 kV verwendet.

Bevorzugt wird dazu eine Kapillare aus Quarzglas mit einer äußeren Beschichtung aus Polyimid verwendet. Alternativ können als Materialien auch PEEK, Teflon^{®}, oder Borosilikatglas verwendet werden.

Die Kapillare weist bevorzugt einen Innendurchmesser zwischen 50 und 400 µm auf. Der Durchmesser des Elektrodendrahtes ist entsprechend kleiner.

Je nach Anwendungsfall ist vorgesehen, dass die gasförmige Probe durch die Kapillare zugeführt wird oder dass die gasförmige Probe ohne Durchtritt durch die Kapillare von außen in den Austrittsbereich der Kapillare geführt wird.

Die Erfindung ist nachstehend anhand der Zeichnung beispielhaft näher erläutert. Diese zeigt jeweils in vergrößerter schematischer Darstellung in
Fig. 1 eine Prinzipdarstellung einer Kapillare mit einer Elektrode,
Fig. 2 zeigt ein vergleichendes Beispiel einer Kapillare mit zwei Elektroden welches nicht Teil der beanspruchten Erfindung ist,
Fig. 3 die Kapillare nach Fig. 1 mit einem Plasma P1,
Fig. 4 die Kapillare nach Fig. 1 mit einem Plasma P1 und einem Plasma P2,
Fig. 5 die Kapillare nach Fig. 2, welche nicht Teil der beanspruchten Erfindung ist, mit einem Plasma P3,
Fig. 6 die Kapillare nach Fig. 1 mit den Plasmen P1, P2 und P3 und in
Fig. 7 die Kapillare nach Fig. 2, welche nicht Teil der beanspruchten Erfindung ist, mit den Plasmen P1, P2 und P3.

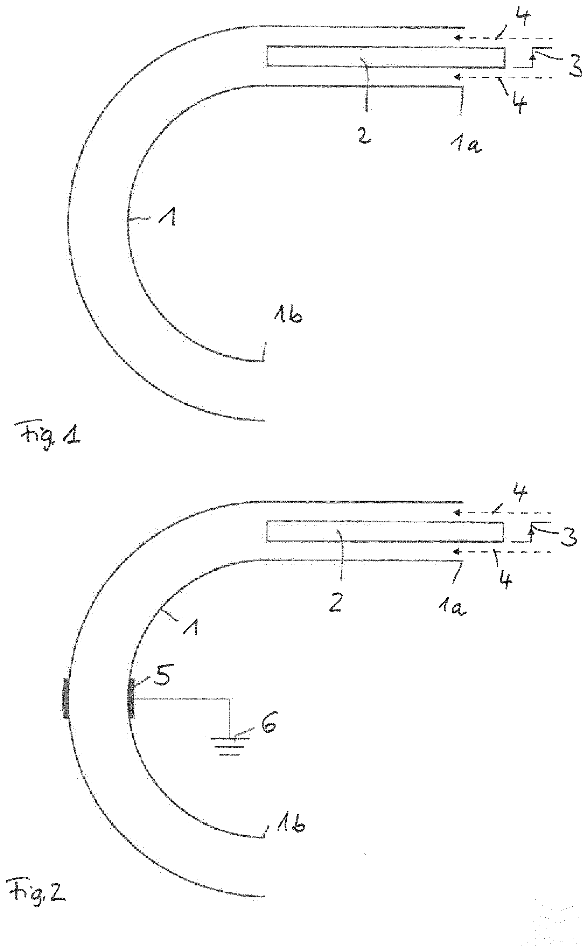

In Fig. 1 ist schematisch eine Kapillare 1 zur Durchführung des erfindungsgemäßen Verfahrens dargestellt. Diese Kapillare 1 besteht aus einem dielektrischen Material, zum Beispiel Quarzglas, und ist flexibel und biegbar ausgebildet. Dazu ist die Kapillare 1 an der Außenseite zum Beispiel mit einer nicht dargestellten Beschichtung aus Polyimid versehen. Die Kapillare 1 weist dabei einen Innendurchmesser zwischen 50 und 400 µm auf. Am hinteren Ende 1a der Kapillare 1 ist in die Kapillare 1 eine drahtförmige Elektrode 2 eingesetzt. Diese Elektrode 2 ist hochspannungsseitig an eine nicht dargestellte Hochspannungsquelle angeschlossen, vorzugsweise eine Rechteckspannungsquelle. Diese Rechteckspannung ist durch ein Spannungssymbol 3 angedeutet. Diese Rechteckspannung weist eine Größenordnung von 1 kV bis 4 kV und eine Frequenz zwischen 5 kHz bis 60 kHz auf. Eine weitere Elektrode ist bei der Ausführungsform nach Figur 1 nicht vorgesehen. Angrenzend an das vordere Ende 1b ist in einem geringen Abstand von zum Beispiel 1 cm ein Eingang in ein Massenspektrometer angeordnet oder das vordere Ende 1b mündet in einem Ionisationsraum eines Ionenbeweglichkeitsspektrometers. Die zweite Elektrode wird bei dieser Ausführungsform der Kapillare 1 von der Umgebung bzw. dem Gehäuse des Analysegerätes gebildet. Die Umgebung der Kapillare 1 wirkt dann wie ein Kondensator.

In das hintere Ende 1a der Kapillare 1 wird ein Plasmagas eingeleitet, was durch gestrichelte Pfeile 4 angedeutet ist. Das zu ionisierende Probengas wird entweder ebenfalls durch das hintere Ende 1a der Kapillare 1 eingeleitet und somit durch die Kapillare 1 geleitet oder es wird von außen dem Bereich des Austritts aus der Kapillare 1, also am vorderen Ende 1b zugeführt, ohne dass es durch die Kapillare 1 strömt.

Figur 2 zeigt ein vergleichendes Beispiel einer Kapillare mit zwei Elektroden, das nicht Teil der beanspruchten Erfindung ist.

In Figur 2 ist dieselbe Kapillare 1 wie in Figur 1 dargestellt mit dem Unterschied, dass außenseitig zum Beispiel im mittleren Längenbereich der Kapillare 1 eine vorzugsweise ringförmige zweite Elektrode 5 angeordnet ist, welche durch die dielektrische Wandung der Kapillare 1 vom Innenraum der Kapillare 1 getrennt ist. Die zweite Elektrode 5 ist an die Masse der Hochspannungsquelle angeschlossen, was durch ein Massesymbol 6 angedeutet ist.

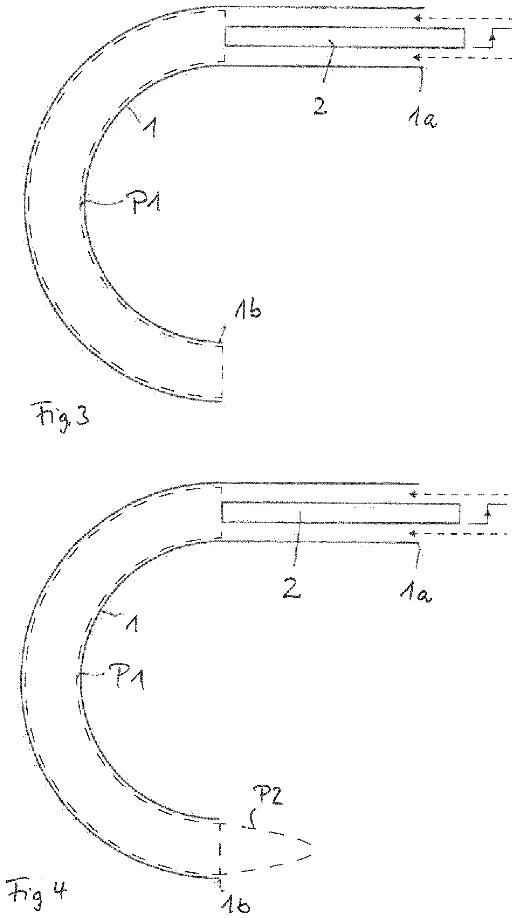

In den Figuren 3 bis 7 sind verschiedene Beispiele der unterschiedlichen Plasmaausbildung dargestellt:
In Figur 3 ist ein Plasma P1 dargestellt, das sich von der Spitze der Elektrode 2 bis zum vorderen Ende 1b der Kapillare 1 erstreckt.

In Figur 4 ist eine Situation dargestellt, in welcher sich neben dem Plasma P1 am Austritt aus der Kapillare 1 ein Plasma P2 bildet.

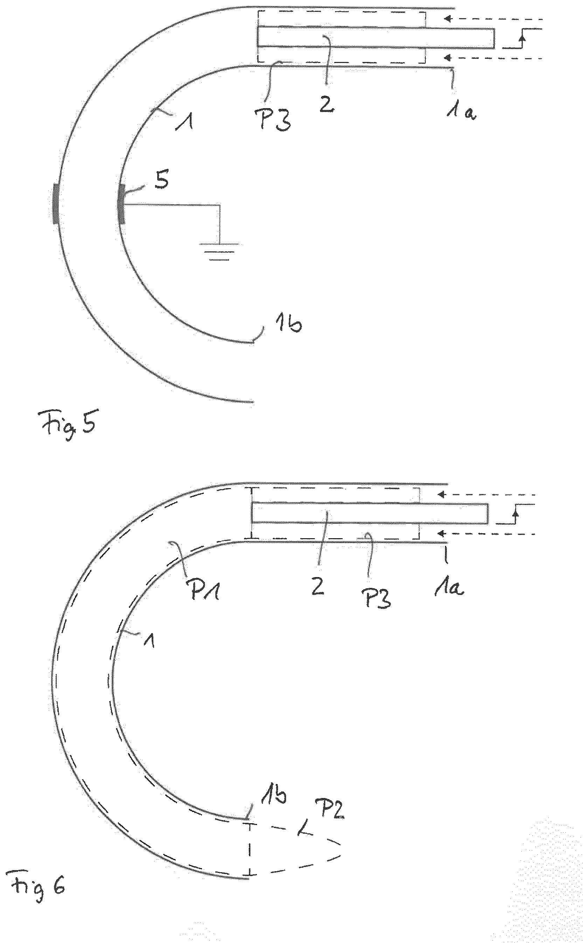

Figur 5 zeigt ein vergleichendes Beispiel einer Kapillare mit zwei Elektroden, das nicht Teil der beanspruchten Erfindung ist.

In Figur 5 ist die Kapillare 1 mit der ersten Elektrode 2 und der zweiten Elektrode 5 dargestellt, wobei sich ein drittes Plasma P3 nur im Bereich der Elektrode 2 ausbildet.

Figur 6 zeigt eine Situation mit der Kapillare 1 ohne zweiter Elektrode 5, in welcher alle Plasmen P1, P2 und P3 ausgebildet sind.

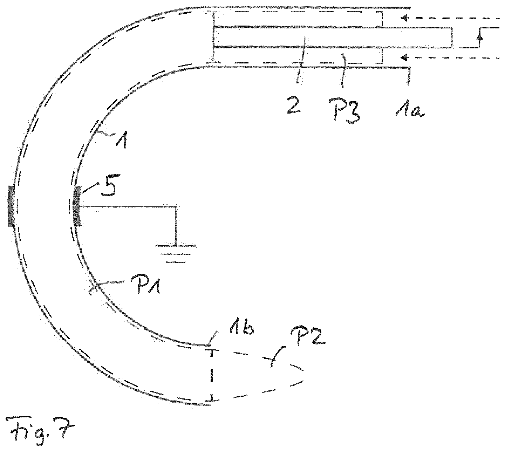

Schließlich zeigt Figur 7 eine Situation mit der Kapillare 1 mit zweite Elektrode 5, in welcher ebenfalls alle Plasmen P1, P2 und P3 ausgebildet sind. Die in Figur 7 gezeigte Situation ist nicht Teil der beanspruchten Erfindung.

Das Vorhandensein der verschiedenen Plasmen P1, P2, P3 und die Ausdehnung des jeweiligen Plasmas hängt von den gewählten Geometrien (Innendurchmesser der Kapillare 1 und Durchmesser der drahtförmige Elektrode 2) und dem jeweils verwendeten Plasmagas ab. Grundsätzlich verhält es sich so, dass zunächst das Plasma P1 an der Spitze der Elektrode 2 zündet und sich dieses Plasma P1 dann bei Erhöhung der Spannung entlang des Kanals innerhalb der Kapillare 1 immer weiter ausdehnt, diese Ausdehnung kann durch die zusätzliche Elektrode 5 begünstigt werden. Nach dem Erreichen des vorderen Endes 1b der Kapillare 1 entsteht neben dem Plasma P1 zusätzlich das kleinere Plasma P2.

Bei weiterer Spannungserhöhung kann zusätzlich das weitere Plasma P3 entstehen, insbesondere wenn als Plasmagas Helium oder Argon verwendet wird.

### Bezugszeichenliste:

- 1: Kapillare
- 1a: hinteres Ende
- 1b: vorderes Ende
- 2: Elektrode
- 3: Spannungssymbol
- 4: Pfeile
- 5: Elektrode
- 6: Massesymbol
- P1: Plasma
- P2: Plasma
- P3: Plasma

## Patentansprüche

1. Verfahren zur Ionisierung von gasförmigen Proben mittels dielektrisch behinderter Entladung und zur nachfolgenden Analyse der erzeugten Probenionen in einem Analysegerät, insbesondere einem Massenspektrometer oder einem Ionenbeweglichkeitsspektrometer, wobei die Probenionen durch ein Plasma erzeugt werden, welches durch eine dielektrisch behinderte Entladung hervorgerufen wird, wobei die dielektrisch behinderte Entladung dadurch erzeugt wird, dass ein Plasmagas in ein hinteres Ende (1a) einer Kapillare (1) aus einem dielektrischen Material in die Kapillare (1) eingeleitet wird, wobei innerhalb der Kapillare (1) eine drahtförmige Elektrode (2) angeordnet ist, die hochspannungsseitig an eine Wechselspannungsquelle angeschlossen wird, wobei die gasförmige Probe dem Austrittsbereich der Kapillare (1) zugeführt wird,
**dadurch gekennzeichnet,**
**dass** eine flexible, biegbare Kapillare (1) verwendet und die drahtförmige Elektrode nur in das hintere Ende (1a) der Kapillare (1) eingesetzt wird, wobei keine an die Masse der Hochspannungsquelle angeschlossene Elektrode verwendet wird.

2. Verfahren nach Anspruch 1,
**dadurch gekennzeichnet,**
**dass** als Plasmagas Helium, Argon, Wasserstoff, Stickstoff oder Luft verwendet wird.

3. Verfahren nach Anspruch 1 oder 2,
**dadurch gekennzeichnet,**
**dass** als Wechselspannung eine Rechteckspannung verwendet wird.

4. Verfahren nach einem oder mehreren der Ansprüche 1 bis 3,
**dadurch gekennzeichnet,**
**dass** die Frequenz der Rechteckspannung 5 bis 60 kHz beträgt.

5. Verfahren nach Anspruch 3 oder 4,
**dadurch gekennzeichnet,**
**dass** eine Rechteckspannung im Bereich von 1 bis 4 kV verwendet wird.

6. Verfahren nach einem oder mehreren der Ansprüche 1 bis 5,
**dadurch gekennzeichnet,**
**dass** eine Kapillare aus Quarzglas mit einer äußeren Beschichtung aus Polyimid verwendet wird.

7. Verfahren nach einem oder mehreren der Ansprüche 1 bis 6,
**dadurch gekennzeichnet,**
**dass** eine Kapillare mit einem Innendurchmesser zwischen 50 und 400 µm verwendet wird.

8. Verfahren nach einem oder mehreren der Ansprüche 1 bis 7,
**dadurch gekennzeichnet,**
**dass** die gasförmige Probe durch die Kapillare zugeführt wird.

9. Verfahren nach einem oder mehreren der Ansprüche 1 bis 7,
**dadurch gekennzeichnet,**
**dass** die gasförmige Probe ohne Durchtritt durch die Kapillare von außen in den Austrittsbereich der Kapillare geführt wird.

## Claims

1. Method for ionizing gaseous samples by means of a dielectric barrier discharge and for subsequently analyzing the produced sample ions in an analysis appliance, in particular a mass spectrometer or an ion mobility spectrometer, wherein the sample ions are generated by a plasma which is created by a dielectric barrier discharge, wherein the dielectric barrier discharge is generated in that a plasma gas is introduced into a rear end (1a) of a capillary tube (1) made of a dielectric material into the capillary tube (1), wherein within the capillary tube (1) a wire-like electrode (2) is arranged, which is connected on the high-voltage side to an AC voltage source, wherein the gaseous sample is supplied to the outlet region of the capillary tube (1),
**characterised in that**
a flexible, bendable capillary tube (1) is used and the wire-like electrode is inserted only into the rear end (1a) of the capillary tube (1), wherein no electrode is used which is connected to the mass of the high-voltage source.

2. Method according to claim 1,
**characterised in that**
helium, argon, hydrogen, nitrogen or air is used as a plasma gas.

3. Method according to claim 1 or 2,
**characterised in that**
a square-wave voltage is used as an AC voltage.

4. Method according to one or more of claims 1 to 3,
**characterised in that**
the frequency of the square-wave voltage is 5 to 60 kHz.

5. Method according to claim 3 or 4,
**characterised in that**
a square-wave voltage in the range from 1 to 4 kV is used.

6. Method according to one or more of claims 1 to 5,
**characterised in that**
a capillary tube made of quartz glass with an outer coating of polyimide is used.

7. Method according to one or more of claims 1 to 6,
**characterised in that**
a capillary tube with an inner diameter of between 50 and 400 µm is used.

8. Method according to one or more of claims 1 to 7,
**characterised in that**
the gaseous sample is supplied through the capillary tube.

9. Method according to one or more of claims 1 to 7,
**characterised in that**
the gaseous sample is guided from the outside into the outlet region of the capillary tube without having passed through the capillary tube.

## Revendications

1. Procédé d'ionisation d'échantillons gazeux au moyen d'une décharge à barrière diélectrique et d'analyse ultérieure des ions d'échantillon générés dans un appareil d'analyse, en particulier un spectromètre de masse ou un spectromètre à mobilité ionique, dans lequel les ions d'échantillon sont générés par un plasma qui est créé par une décharge à barrière diélectrique, dans lequel la décharge à barrière diélectrique est générée par le fait qu'un gaz de plasma est introduit dans une extrémité arrière (1a) d'un capillaire (1) d'un matériau diélectrique dans le capillaire (1), dans lequel une électrode (2) en forme de fil est disposée à l'intérieur du capillaire (1), électrode qui est raccordée côté haute tension à une source de tension alternative, dans lequel l'échantillon gazeux est acheminé vers la zone de sortie du capillaire (1),
**caractérisé en ce que**
un capillaire flexible et pliable (1) est utilisé et **en ce que** l'électrode en forme de fil est insérée uniquement dans l'extrémité arrière (1a) du capillaire (1), dans lequel aucune électrode raccordée à la masse de la source de haute tension n'est utilisée.

2. Procédé selon la revendication 1,
**caractérisé en ce que**
de l'hélium, de l'argon, de l'hydrogène, de l'azote ou de l'air est utilisé comme gaz plasmagène.

3. Procédé selon la revendication 1 ou 2,
**caractérisé en ce que**
une tension rectangulaire est utilisée comme tension alternative.

4. Procédé selon une ou plusieurs des revendications 1 à 3,
**caractérisé en ce que**
la fréquence de la tension rectangulaire est comprise entre 5 et 60 kHz.

5. Procédé selon la revendication 3 ou 4,
**caractérisé en ce que**
une tension rectangulaire dans la plage de 1 à 4 kV est utilisée.

6. Procédé selon une ou plusieurs des revendications 1 à 5,
**caractérisé en ce que**
un capillaire en verre de quartz avec un revêtement extérieur en polyimide est utilisé.

7. Procédé selon une ou plusieurs des revendications 1 à 6,
**caractérisé en ce que**
un capillaire avec un diamètre intérieur compris entre 50 et 400 µm est utilisé.

8. Procédé selon une ou plusieurs des revendications 1 à 7,
**caractérisé en ce que**
l'échantillon gazeux est acheminé à travers le capillaire.

9. Procédé selon une ou plusieurs des revendications 1 à 7,
**caractérisé en ce que**
l'échantillon gazeux est guidé de l'extérieur dans la zone de sortie du capillaire sans passer par le capillaire.
